# EUROPÄISCHE PATENTSCHRIFT

(11) **EP 2 745 327 B1**
(45) Veröffentlichungstag und Bekanntmachung des Hinweises auf die Patenterteilung: **27.06.2018**
(21) Anmeldenummer: 12756650.3
(22) Anmeldetag: 14.08.2012
(51) Int. Cl.: H01L 31/02, H02S 40/34

(54) **ANSCHLUSSDOSE FÜR EIN SOLARPANEL MIT EINER SCHUTZSCHALTUNG**
SOCKET FOR A SOLAR PANEL WITH A PROTECTIVE CIRCUIT
BOÎTE DE CONNEXIONS POUR UN PANNEAU SOLAIRE, POURVUE D'UN CIRCUIT DE PROTECTION

(30) Priorität: 19.08.2011 DE 102011110682
(43) Veröffentlichungstag der Anmeldung: 25.06.2014
(73) Patentinhaber: Phoenix Contact GmbH & Co. KG, 32825 Blomberg (DE)
(72) Erfinder: JANKOWSKI, Martin, 30926 Seelze (DE)
(74) Vertreter: Blumbach · Zinngrebe Patent- und Rechtsanwälte
(86) Internationale Anmeldenummer: PCT/EP2012/003459
(87) Internationale Veröffentlichungsnummer: WO 2013/026539

(56) Entgegenhaltungen:
- EP-A1- 2 256 819
- WO-A2-2011/023732
- US-A1- 2010 139 734
- US-A1- 2011 172 842

## Beschreibung

### Gebiet der Erfindung

Die Erfindung betrifft eine Anschlussdose für ein Solarpanel mit einer Schutzschaltung, insbesondere zum selektiven Freischalten eines oder mehrerer Solarpanele eines Solargenerators von den externen Anschlussleitungen.

### Hintergrund der Erfindung

Solarpanele weisen typischerweise eine Anschlussdose, die teilweise auch als PV-(Photovoltaik-)Anschlussdose, (PV-)Anschluss- und Verbindungsdose oder (PV-)Anschlussbox bezeichnet wird, auf. Diese Anschlussdose weist ein typischerweise flaches dielektrisches Gehäuse auf und ist auf der Sonnen-abgewandten Rückseite des Solarpanels befestigt, z.B. aufgeklebt. Die Solarpanele weisen spannungsführende Leiter auf, typischerweise in Form von dünnen Leiterbändchen, den sogenannten Ribbons, welche aus der Rückseite der Solarpanele heraustreten und die elektrischen Pole des Solarpanels bilden, d.h. zwischen denen die von dem Solarpanel erzeugte Spannung anliegt. Ein Solarpanel weist typischerweise eine Mehrzahl von in dem Solarpanel seriell und/oder parallel geschaltete Solarzellen auf. Ggf. werden noch ein oder mehrere Zwischenabgriffe zwischen den Solarzellen oder Gruppen von Solarzellen des Solarpanels aus diesem herausgeführt und in der Anschlussdose kontaktiert. Die Anschlussdose für das Solarpanel enthält im Inneren üblicherweise eingangsseitige Anschlusselemente, z.B. Federkraftklemmen mit welchen die durch den Boden der Anschlussdose ins Innere des Anschlussdosengehäuses ragenden Leiterbändchen des Pluspols und des Minuspols des Solarpanels angeschlossen bzw. kontaktiert werden sowie eine Bypass-Diode für das Solarpanel und ggf. weitere Anschlusselemente und weitere Bypass-Dioden bei Solarpanelen mit einem oder mehreren Zwischenabgriffen.

Die Anschlussdose weist ferner ausgangsseitige Anschlusselemente, z.B. in Form von Federkraftklemmen oder Steckverbindern zum Anschließen der externen Anschlussleitungen auf, so dass die erste und zweite externe Anschlussleitung mittels der ausgangsseitigen Anschlusselemente und der hiermit innerhalb der Anschlussdose verbundenen eingangsseitigen Anschlusselemente mit dem Pluspol bzw. dem Minuspol des Solarpanels elektrisch verbunden werden können, um die Solarpanele zu verkabeln.

Beispiele für derartige Anschlussdosen für Solarpanele sind in der DE 10 2007 037 130 und der DE 10 2007 042 547 beschrieben.

Ein Solargenerator besteht typischerweise aus einer Mehrzahl von Solarpanelen, welche selbst wiederum zu Strängen (sogenannte Strings) in Serie geschaltet sind, um eine Solargeneratorgleichspannung von typischerweise derzeit bis zu 1000 V zu erreichen. Ferner werden je nach Anzahl der zusammen geschalteten Solarpanele und deren Einzelspannung wiederum ggf. mehrere der Stränge parallel geschaltet. Aufgrund der hohen Spannung im Gleichspannungsteil der Solaranlage und der auftretenden Ströme, die im Ampere-Bereich liegen können, besteht bei Störfällen, wie z.B. bei einem Brand, die akute Gefahr, dass Rettungskräfte lebensgefährlichen Spannungen ausgesetzt sein könnten. Insbesondere die Feuerwehr würde beim Löschen eines brennenden Dachstuhls mit einer Solaranlage Gefahr laufen, über das Löschwasser lebensgefährlichen elektrischen Spannungen ausgesetzt zu sein. Diese Gefahr besteht insbesondere tagsüber, aber selbst nachts kann bei größeren Anlagen sogar das vorhandene Restlicht noch zu gefährlichen Spannungen führen. Derartige Gefahren bestehen allerdings nicht nur im Brandfall, sondern können auch bei anderen außergewöhnlichen Störfällen oder Unfällen bestehen, z.B. bei Sturmschäden oder Kraftfahrzeugkollisionen mit Freifeldanlagen, um nur einige Beispiele ohne Anspruch auf Vollständigkeit zu nennen.

Zwar weist eine Solaranlage typischerweise im sogenannten Generatoranschlusskasten einen Haupttrennschalter auf, allerdings lässt sich hiermit, z.B. bei Schäden durch Feuer, Wasser, Hagel etc. an den Solarpanelen oder an den Anschlussleitungen nicht der Bereich vor dem Generatoranschlusskasten freischalten. Ferner ist eine selektive Freischaltung einzelner Solarpanele ebenfalls nicht möglich.

Darüber hinaus erzeugen Solarpanele jederzeit Spannung, wenn sie beleuchtet werden, was bereits bei der Montage der Solar-Anschlussdosen auf dem Solarpanel, der Lagerung, dem Transport und insbesondere bei der Montage der Solarpanele am Bestimmungsort der Fall sein kann. Daher kann es z.B. bereits während der Montage der Solarpanele und beim Anschließen der Anschlussleitungen bei entsprechender Beleuchtung zu hohen Spannungen kommen, die einen sicheren Umgang und einen besonderen Berührungsschutz bedürfen. Selbst ein einzelnes Solarpanel kann aufgrund einer Serienschaltung von mehreren Solarzellen in dem Solarpanel bereits eine Spannung erzeugen, welche Sicherheitsvorkehrungen erfordert. Daher werden typischerweise berührgeschützte Steckverbinder, z.B. aus dem SUNCLIX®-System der Anmelderin verwendet, welche bereits eine hohe Sicherheit gewährleisten. Allerdings kann es dennoch wünschenswert sein, den Solargenerator zur Erhöhung der Sicherheit soweit wie möglich spannungsfrei zu schalten und zwar vor dem Haupttrennschalter, insbesondere direkt an den Solarpanelen.

Aus der DE 10 2009 024 516 A1, oder der WO-A-2011/023732 ist eine Sicherheitseinrichtung für eine Anschlussdose für den elektrischen Anschluss eines Solarpanels bekannt, welche in der Anschlussdose eine elektrisch leitende Querverbindung zwischen den Anschlusselementen herstellt, so dass im aktiven Zustand die Ausgangsspannung zu null reduziert wird.

Wenn die Querverbindung hergestellt ist, entsteht allerdings ein Leistungsverlust an der Sicherheitseinrichtung, was ggf. zu unerwünschter Erwärmung führen kann. Ein dauerhaftes Verbleiben in diesem Zustand kann unter Umständen zu einer Beschädigung der Sicherheitseinrichtung oder der Solarpanele führen.

Ferner ist diese Sicherheitseinrichtung vor allem zum Kurzschließen im Brandfall, d.h. einem Störfall im laufenden Betrieb gedacht. Das Verbringen der Sicherheitseinrichtung in den Zustand, in dem die Ausgangsspannung zu null reduziert ist, erfordert hierzu einen aktiven Steuereingriff. Bei einem Störfall, wie zum Beispiel einem Brand kann die Sicherheitseinrichtung unter Umständen zum Zeitpunkt der gewünschten Aktivierung, z.B. durch die angerückte Feuerwehr, selbst bereits beschädigt oder zerstört sein, so dass die Sicherheitseinrichtung zu diesem Zeitpunkt möglicherweise nicht mehr aktivierbar somit und die gewünschte Sicherheitsfunktionalität nicht mehr wirksam ist.

Demnach existieren zwar bereits verschiedene Sicherheitsmaßnahmen für Photovoltaikgeneratoren, nichtsdestotrotz sind diese weiter verbesserungsfähig.

### Allgemeine Beschreibung der Erfindung

Die Erfindung hat sich daher die Aufgabe gestellt, eine Anschlussdose für ein Solarpanel mit einer Schutzschaltung bzw. eine Schutzschaltung bereit zu stellen, welche ein hohes Maß an Sicherheit bei Störfällen gewährleistet.

Eine weitere Aufgabe der Erfindung ist es, eine Anschlussdose für ein Solarpanel mit einer Schutzschaltung bzw. eine Schutzschaltung bereit zu stellen, welche über einen langen Zeitraum im Schutzzustand verbleiben kann und ein hohes Maß an Sicherheit auch während der Lagerung, dem Transport und der Montage sowie eine komfortable Montage gewährleistet.

Noch eine Aufgabe der Erfindung ist es, eine Anschlussdose für ein Solarpanel mit einer Schutzschaltung bzw. eine Schutzschaltung bereit zu stellen, welche in einem Störfall selbsttätig in den Schutzzustand übergeht, ggf. noch bei teilweiser Zerstörung, und bei der die Anschlussdose auch in dem Schutzzustand noch bestimmte Funktionen bereit stellen kann.

Die Aufgabe der Erfindung wird durch den Gegenstand der unabhängigen Ansprüche gelöst. Vorteilhafte Weiterbildungen der Erfindung sind in den Unteransprüchen definiert.

Erfindungsgemäß wird eine Anschlussdose für ein Solarpanel zum elektrischen Anschließen von externen Anschlussleitungen an ein Solarpanel bereit gestellt. Die Anschlussdose umfasst ein auf dem Solarpanel befestigbares Anschlussdosengehäuse, welches insbesondere eine auf das Solarpanel auflegbare Unterseite mit Öffnungen zum Einführen der aus dem Solarpanel heraustretenden spannungsführenden Leiter in die Anschlussdose aufweist. Diese spannungsführenden Leiter des Pluspols und des Minuspols des Solarpanels sind zumeist als dünne Leiterbändchen, sogenannte Ribbons ausgebildet. An der Unterseite hat das hutartig ausgebildete Anschlussdosengehäuse z. B. einen umlaufenden Kleberand, mit welchem das Anschlussdosengehäuse auf die Sonnenabgewandte Rückseite des Solarpanels aufgeklebt wird. In dem Anschlussdosegehäuse sind die vom Solarpanel kommenden und sich in die Anschlussdose hinein erstreckenden Leiterbändchen mittels eingangsseitiger Anschlusselemente, z.B. Federkraftklemmen elektrisch angeschlossen. Somit weist die Anschlussdose zumindest ein eingangsseitiges elektrisches Anschlusselement für das Pluspol-Leiterbändchen und ein eingangsseitiges elektrisches Anschlusselement für das Minuspol-Leiterbändchen auf.

Die Anschlussdose umfasst ferner zumindest ein erstes und zweites ausgangsseitiges Anschlusselement zum Anschließen einer ersten und zweiten externen Anschlussleitung, z.B. der beiden Strangkabel, mit denen das Solarpanel mit weiteren Solarpanelen zusammen geschaltet, z.B. mit den jeweils benachbarten Solarpanelen in Reihe geschaltet ist. Die Anschlusselemente für die externen Anschlusskabel können z.B. als Klemmen ausgebildet sein, mittels welchen das in die Anschlussdose eingeführte Leiterende des jeweiligen Strangkabels kontaktiert wird oder die Anschlussdose weist selbst bereits Steckverbinder zum Anschließen des jeweiligen Strangkabels auf.

In das Anschlussdosengehäuse ist ferner eine elektrische bzw. elektronische Schutzschaltung eingebaut, die einen Betriebszustand und einen Schutzzustand definiert. In dem Betriebszustand ist das jeweilige Solarpanel mit den stromabnehmenden Einrichtungen, also bei einer netzgekoppelten Solaranlage mit dem Stromnetz verbunden und speist seine elektrische Leistung in das Stromnetz ein. Demnach ist in dem Betriebszustand die erste externe Anschlussleitung mit dem spannungsführenden Leiter des Pluspols des Solarpanels und die zweite externe Anschlussleitung mit dem spannungsführenden Leiter des Minuspols des Solarpanels elektrisch verbunden, so dass die von dem Solarpanel erzeugte elektrische Leistung über die erste und zweite externe Anschlussleitung in das Stromnetz eingespeist werden kann.

Die Schutzschaltung umfasst einen Kurzschlussschalter zwischen den ausgangsseitigen Anschlusselementen der ersten und zweiten externen Anschlussleitung und einen Freischalter zwischen dem Kurzschlussschalter und einem der beiden Pole des Solarpanels. Der Kurzschlussschalter ist in dem Betriebszustand geöffnet, so dass die elektrische Leistung des Solarpanels ins Netz eingespeist werden kann und in dem Schutzzustand sind die ausgangsseitigen Anschlusselemente der ersten und zweiten externen Anschlussleitung innerhalb der Anschlussdose kurzgeschlossen. Dies bewirkt bereits, das dieses Solarpanel keinen Strom mehr über die Strangleitung abgeben kann. Der Freischalter ist nun seriell zwischen den Leiter des Pluspols des Solarpanels oder den Leiter des Minuspols des Solarpanels und den Kurzschlussschalter geschaltet. In dem Betriebszustand ist folglich der Kurzschlussschalter geöffnet und der Freischalter geschlossen, um den elektrischen Strom des Solarpanels zu den ausgangsseitigen Anschlusselementen zu leiten und einzuspeisen. In dem Schutzzustand ist der Freischalter hingegen geöffnet, um den geschlossenen Kurzschlussschalter zumindest einseitig von den Polen des Solarpanels zu trennen. Somit sind in dem Schutzzustand die externen Anschlussleitungen in Bezug auf dieses Solarpanel leistungsfrei geschaltet, dahingehend dass es einerseits innerhalb der Strangleitung mittels des Kurzschlussschalters überbrückt ist und andererseits zusätzlich zumindest einseitig von den Strangleitungen getrennt wird, so dass das Solarpanel trotz geschlossenem Kurzschlussschalter selbst nicht kurzgeschlossen ist.

Dies hat mehrere Vorteile. Zum einen wird der Kurzschlussschalter nicht durch die Verlustleistung des zugehörigen Solarpanels belastet, sondern wirkt lediglich als niederohmiger Bypass dieses Solarpanels innerhalb der Strangleitung. Dadurch kann die Schutzschaltung ohne nennenswerte Erwärmung auch bei Belichtung des Solarpanels praktisch beliebig lange in dem Schutzzustand verbleiben. Zum anderen ist das zugehörige Solarpanel trotz dieser Kurzschlussüberbrückung selbst nicht kurzgeschlossen, so dass die elektrische Leistung des Solarpanels zwar nicht in die Strangleitung gespeist wird, aber innerhalb der Anschlussdose weiterhin zur Verfügung steht. Somit können elektrische oder elektronische Einrichtungen in der Anschlussdose von dem zugehörigen Solarpanel trotzdem weiter mit elektrischer Energie versorgt werden, obwohl sich die Schutzschaltung in dem Schutzzustand befindet und die Ausgangsseite der Anschlussdose kurzgeschlossen ist.

Der Kurzschlussschalter ist in der Anschlussdose von den Polen des Solarpanels aus gesehen insbesondere direkt vor den ausgangsseitigen Anschlusselementen der ersten und zweiten externen Anschlussleitung, z.B. den Anschlussklemmen für die abisolierten Enden der Strangleitung innerhalb des Anschlussdosengehäuses oder der integrierten Steckverbinder für die Strangleitung, angeordnet. Der Freischalter ist in der Anschlussdose seriell unmittelbar zwischen das eingangsseitige Anschlusselement des spannungsführenden Leiters des Pluspols des Solarpanels oder das eingangsseitige Anschlusselement des spannungsführenden Leiters des Minuspols des Solarpanels und einen der Anschlüsse des Kurzschlussschalters geschaltet.

Die Anschlussdose weist vorzugsweise eine übliche Bypassschaltung zur Kompensation von Abschattungen, z.B. eine Bypassdiode, auf. In diesem Fall ist der Freischalter seriell zu der Bypassschaltung zur Kompensation von Abschattungen geschaltet und der Kurzschlussschalter ist parallel zu der Bypassschaltung zur Kompensation von Abschattungen geschaltet. Die Bypassschaltung zur Kompensation von Abschattungen ist von den Polen des Solarpanels aus gesehen vor den Freischalter und den Kurzschlussschalter geschaltet ist, so dass die Bypassschaltung zur Kompensation von Abschattungen auch in dem Schutzzustand mit dem Solarpanel verbunden bleibt und in Betrieb steht. Dies kann insbesondere bei Solarpanelen mit Zwischenabgriffen und mehreren Bypassschaltungen je Solarpanel bzw. Anschlussdose vorteilhaft sein.

Solarpanele weisen typischerweise eine Vielzahl von Solarzellen auf, welche innerhalb des Solarpanels seriell und/oder parallel verschaltet sind. Häufig besitzen dann die Solarpanele Zwischenabgriffe, an welchen die elektrische Leistung innerhalb der in dem Solarpanel seriell und/oder parallel zu Gruppen zusammen geschalteten Solarzellen abgegriffen wird. Diese Gruppen können dann mittels der Anschlussdose separat kontaktiert werden. Hierzu umfasst die Anschlussdose in dem Anschlussdosengehäuse weitere eingangsseitige Anschlusselemente zum Anschließen der vom Solarpanel kommenden Leiterbändchen der Zwischenabgriffe sowie mehrere Bypassschaltungen zur Kompensation von Abschattungen jeweils zwischen den eingangsseitigen Anschlusselementen für die Leiterbändchen des Pluspols, der Zwischenabgriffe und des Minuspols des Solarpanels. Die Bypassschaltungen sind demnach jeweils parallel zu den separat mit der Anschlussdose kontaktierten Teilabschnitten des jeweiligen Solarpanels geschaltet, wenn die Anschlussdose auf dem Solarpanel montiert ist. In diesem Fall ist der Kurzschlussschalter parallel zu allen Bypassschaltungen zur Kompensation von Abschattungen und zu allen Gruppen von Solarzellen bzw. separat kontaktierten Teilabschnitten des Solarpanels geschaltet und der Freischalter ist in Serie zwischen den Kurzschlussschalter und alle Bypassschaltungen zur Kompensation von Abschattungen und allen separat kontaktierten Teilabschnitten des Solarpanels geschaltet. Somit ist im Schutzzustand der Kurzschlussschalter mittels des Freischalters von allen separat kontaktierten Teilabschnitten des Solarpanels und von allen Bypassschaltungen zur Kompensation von Abschattungen zu getrennt.

Insbesondere ist die Schutzschaltung bzw. sind der Kurzschlussschalter und der Freischalter in dem Anschlussdosengehäuse von den Polen des Solarpanels aus gesehen vor jeglichen außerhalb des Anschlussdosengehäuses liegenden lösbaren Verbindern eingebaut. Damit kann sichergestellt werden, dass jegliche lösbare Kabelverbindung außerhalb des Anschlussdosengehäuses leistungsfrei geschaltet werden kann, wodurch ein hoher Sicherheitsstandard erreicht wird.

Gemäß einer Ausführungsform der Erfindung umfasst die Anschlussdose eine Steuereinrichtung, welche das Umschalten der Schutzschaltung, genauer des Kurzschlussschalters und des Freischalters, vom Schutzzustand in den Betriebszustand steuert. Die Steuereinrichtung ist von den Polen des Solarpanels gesehen vor dem Freischalter angeordnet und kann somit nicht nur in dem Betriebszustand, sondern auch in dem Schutzzustand von dem zugehörigen Solarpanel mit elektrischer Energie versorgt werden, da die Steuereinrichtung in dem Schutzzustand mittels des Freischalters zumindest einseitig von dem Kurzschlussschalter getrennt wird, aber mit den Solarzellen verbunden bleibt. Somit kann die Steuereinrichtung zum Steuern der Schalter der Schutzschaltung mit elektrischer Energie versorgt werden und zwar nicht nur in dem Betriebszustand, sondern auch in dem Schutzzustand. Ferner ist die Schutzschaltung insbesondere reversibel ausgestaltet, so dass sie beliebig oft vom Betriebszustand in den Schutzzustand und wieder zurück geschaltet werden kann. Daher kann die hier offenbarte Schutzschaltung nicht nur einmalig, z.B. im Brandfall in den Schutzstand geschaltet werden, sondern ohne manuellen Eingriff in die Anschlussdose reversibel z.B. auch bei Aufbau und Montage sowie bei Wartungsarbeiten. Weiter vorteilhaft ist, dass die Solarpanele einzeln in den Schutzzustand geschaltet werden können, d.h. einzeln von dem Strang abgeschaltet werden können.

In einer einfachen Ausführungsform besteht die Schutzschaltung lediglich aus der Steuereinrichtung, einem Kurzschlussschalter und einem Freischalter. Zweckmäßig sind der Kurzschlussschalter und/oder der Freischalter als mechanische Schalter, elektromechanische Schalter oder Halbleiterschalter ausgebildet.

In einer bevorzugten Ausführungsform ist der Kurzschlussschalter als Öffner ausgebildet, welcher in dem Ruhezustand geschlossen ist. Der Freischalter ist als Schließer ausgebildet und im Ruhezustand geöffnet. Dadurch wird in vorteilhafter Weise erreicht, dass der Kurzschlussschalter und der Freischalter selbsttätig automatisch in den Ruhezustand umschalten, wenn diese von dem Solarpanel nicht mehr mit elektrischer Energie versorgt werden. Daher kann die Schutzschaltung sogar bei absoluter Dunkelheit, bei einer Unterbrechung der elektrischen Verbindung zu dem zugehörigen Solarpanel, z.B. bei einem fehlerhaften Kontakt an den Leiterbändchen oder in einem späten Brandstadium, wenn das Solarmodul bereits zerstört ist, noch immer vom Betriebszustand in den Schutzzustand umschalten. Ferner schaltet die Schutzschaltung selbsttätig in den Schutzzustand, wenn die Steuereinrichtung defekt ist. Die Steuerung ist vorzugsweise so ausgebildet, dass die Schutzschaltung, wenn sie einmal in dem Schutzzustand ist, solange in dem Schutzzustand verharrt, bis sie von der Steuereinrichtung aktiviert wird, d.h. aktiv von dem Ruhe-Schutzzustand in den Betriebszustand zurückgeschaltet wird, selbst wenn das zugehörige Solarpanel wieder elektrische Leistung liefern sollte. Hierzu eignet sich z.B. ein als Öffner bzw. Ruhekontakt ausgebildetes Relais für den Kurzschlussschalter und ein als Schließer bzw. Arbeitskontakt ausgebildetes Relais für den Freischalter. Allerdings lässt sich eine Schutzschaltung bei der der Schutzzustand als Ruhezustand ausgebildet ist auch mit einem selbstleitenden MOS-FET (Verarmungstyp) und einem selbstsperrenden MOS-FET (Anreicherungstyp) als Kurzschlussschalter bzw. Freischalter realisieren.

Die Aktivierung vom Schutzzustand in den Betriebszustand erfolgt vorzugsweise ferngesteuert von außerhalb der Anschlussdose, z.B. über eine Funkverbindung oder über die Strangleitungen, z.B. mittels sogenanntem PowerLine Communication.

Vorzugsweise umfasst die Steuereinrichtung eine Sicherheitseinrichtung, welche für die Aktivierung der Schutzschaltung vom Schutzzustand in den Betriebszustand eine Autorisierung, z.B. eine Codeeingabe erfordert. Dies ermöglicht nicht nur Schutz vor einer Umschaltung in den Betriebszustand von nicht autorisiertem Personal, sondern bietet zusätzlich einen inhärenten Diebstahlsschutz, da das Solarpanel ohne den Autorisierungscode von einem Dieb nicht in den Betriebszustand freigeschaltet werden kann, ohne die Anschlussdose zu entfernen.

Trotzdem kann in dem Anschlussdosengehäuse auch noch eine herkömmliche Diebstahlschutzeinrichtung eingebaut sein. Ferner sind in das Anschlussdosengehäuse ggf. eine Maximum-Powerpoint-Tracking-Steuerungseinrichtung, eine Spannungsüberwachungseinrichtung, eine Stromüberwachungseinrichtung und/oder eine Temperaturüberwachungseinrichtung eingebaut, welche von den Polen des Solarpanels aus gesehen vor den Freischalter und den Kurzschlussschalter geschaltet sind. Somit können die Diebstahlschutzeinrichtung, die Maximum-Powerpoint-Tracking-Steuerungseinrichtung, die Spannungsüberwachungseinrichtung, die Stromüberwachungseinrichtung bzw. die Temperaturüberwachungseinrichtung auch in dem Schutzzustand von dem Solarpanel mit elektrischer Leistung versorgt werden.

Demgemäß betrifft die Erfindung auch eine elektrische Schutzschaltung zum Einbau in eine Anschlussdose für ein Solarpanel, mittels welcher die spannungsführenden Leiterbändchen des Pluspols und des Minuspols des Solarpanels einerseits und die Strangleitungen andererseits angeschlossen und elektrisch miteinander verbunden werden,
wobei die Schutzschaltung einen Betriebszustand, in welchem die elektrische Leistung des Solarpanels über die erste und zweite externe Anschlussleitung abgeführt wird und einen Schutzzustand, in welchem das zugehörige Solarpanel von den externen Anschlussleitungen freigeschaltet ist, definiert,
wobei eine Steuereinrichtung zum Steuern der Schutzschaltung umfasst ist,
wobei der Schutzzustand ein Ruhezustand ist, in welchen die Schutzschaltung selbststätig bei Stromlosigkeit fällt und dort verbleibt, solange bis die Schutzschaltung von einem Aktivierungs-Eingriff durch die Steuereinrichtung wieder aktiviert wird und
wobei die Steuereinrichtung in dem Schutzzustand von dem zugehörigen Solarpanel mit elektrischer Leistung versorgt wird, wenn die Schutzschaltung in der Anschlussdose auf einem Solarpanel eingebaut ist, um die Schutzschaltung aus dem Schutzzustand in den Betriebszustand aktivieren zu können.

Zum Liefern und Aufbauen eines Solargenerators werden die Solarpanele herstellerseitig jeweils mit einer Anschlussdose mit integrierter Schutzschaltung bestückt und in dem Schutzzustand an den Aufbauort, z.B. ein Gebäudedach, geliefert. Am Aufbauort werden die Solarpanele installiert und mit den Strangleitungen verkabelt. Nachfolgend wird der Solargenerator Norm-gerechten Inbetriebnahmeprüfungen unterzogen, z.B. nach DIN VDE 0100-600, DIN VDE 0100-600:2008-06, IEC 60364-6:2006 / HD 60364-6:2007 und/oder DIN EN 62446 VDE 0126-23:2010-07. Erst nach der Installation und den Inbetriebnahmeprüfungen des Solargenerators werden die Schutzschaltungen der Solarpanele vom Schutzzustand in den Betriebszustand umgeschaltet und damit die Verkabelung unter elektrische Leistung gesetzt. Hierdurch wird ein besonders hohes Maß an Sicherheit beim Transport, der Lagerung und der Installation der Solarpanele bzw. des Solargenerators gewährleistet.

Wenn das Aktivieren der Schutzschaltung vom Schutzzustand in den Betriebszustand durch die Steuereinrichtung eine Autorisierung, z.B. eine Codeeingabe erfordert, kann ferner sichergestellt werden, dass die einzeln mögliche Aktivierung oder Freischaltung der Solarpanele nur von speziellem zur Abnahme autorisiertem Personal vorgenommen werden kann. Solange keine autorisierte Freischaltung erfolgt ist, bleibt der Solargenerator von den Solarpanelen aus gesehen jenseits der Anschlussdose leistungsfrei.

Das Umschalten vom Betriebszustand in den Schutzzustand, d.h. das Freischalten des Solarpanels von den Strangleitungen kann z.B. zur Wartung und bei einem Störfall unter Belichtung erfolgen. Für Wartungsarbeiten ist es insbesondere vorteilhaft, dass die Solarpanele einzeln freigeschaltet werden können. Beim Freischalten ist es bevorzugt, in der jeweiligen Schutzschaltung zuerst den Kurzschlussschalter zu schließen, um die ausgangsseitigen Anschlusselemente der ersten und zweiten externen Anschlussleitung miteinander kurzzuschließen und damit in der Strangleitung einen Bypass für das jeweilige Solarpanel zu erzeugen und erst in einem nachfolgenden zweiten Schritt den Freischalter zu öffnen und damit den bereits geschlossenen Kurzschlussschalter zumindest von einem Pol des Solarpanels zu trennen.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele miteinander kombiniert werden können.

### Kurzbeschreibung der Figuren

Es zeigen:
- Fig. 1: eine perspektivische Darstellung einer Anschlussdose für ein Solarpanel,
- Fig. 2: eine perspektivische Darstellung eines Stapels von Solarpanelen mit montierter Anschlussdose,
- Fig. 3: eine schematische Darstellung mit Schaltbild einer ersten Ausführungsform der Erfindung im Betriebszustand,
- Fig. 4: die Ausführungsform aus Fig. 3 im Schutzzustand,
- Fig. 5: eine weitere Ausführungsform der Erfindung im Betriebszustand,
- Fig. 6: die Ausführungsform aus Fig. 5 im Schutzzustand,
- Fig. 7: eine weitere Ausführungsform der Erfindung im Schutzzustand.

### Detaillierte Beschreibung der Erfindung

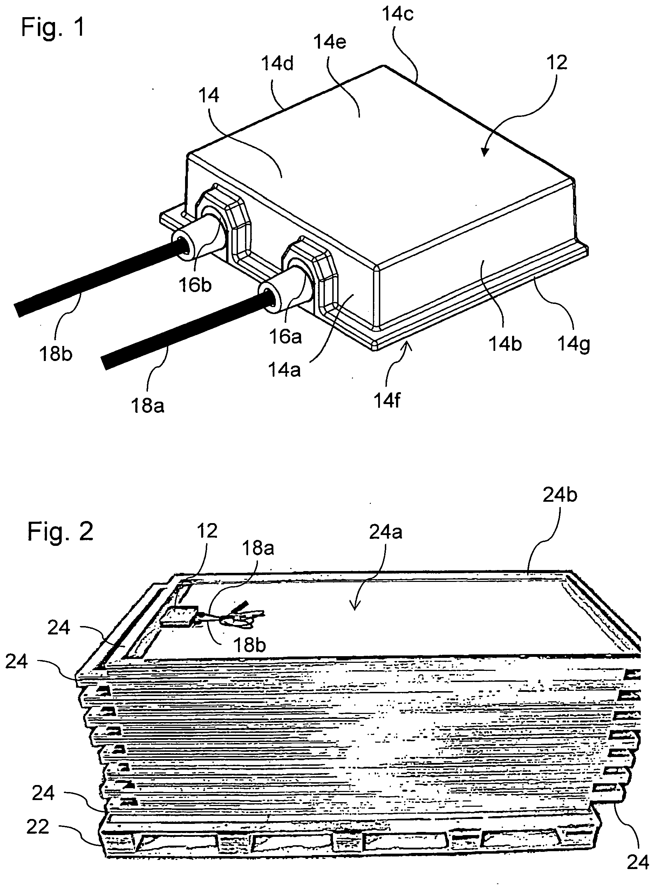

Fig. 1 zeigt eine Anschlussdose 12 mit einem Anschlussdosengehäuse 14 zur Montage auf der Rückseite eines Solarpanels. Das dielektrische Anschlussdosengehäuse 14 ist hutartig ausgebildet und weist umlaufende Seitenwände 14a bis 14d sowie einen Deckel 14e auf. An der in Fig. 1 nicht zu sehenden Unterseite des Anschlussdosengehäuses 14 befinden sich Öffnungen, durch welche die aus dem Solarmodul heraustretenden Leiterbändchen in die Anschlussdose 12 eintreten, um dort angeschlossen bzw. kontaktiert zu werden. Das Anschlussdosengehäuse 14 weist an einer der Seitenwände 14a eine erste und zweite Kabeldurchführung 16a, 16b auf, durch welche die Strangleitungen 18a bzw. 18b in die Anschlussdose 12 geführt und im Inneren des Anschlussdosengehäuses 14 z.B. mittels nicht dargestellter Kontaktklemmen angeschlossen sind, um die von dem Solarpanel erzeugte elektrische Leistung abzuführen. Zum grundsätzlichen mechanischen Aufbau einer Anschlussdose für ein Solarpanel wird z.B. auf die DE 10 2007 037 130 und die DE 10 2007 042 547 verwiesen.

Fig. 2 zeigt 16 auf einer Palette 22 gestapelte Solarpanele 24. Das zu oberst liegend dargestellte Solarpanel 24 liegt mit seiner Rückseite 24a nach oben und auf der Rückseite 24a ist die Anschlussdose 12 mit vorkonfektionierten Strangleitungen 18a und 18b aufgeklebt. Hierzu weist das Anschlussdosengehäuse 14 an seiner Unterseite 14f einen umlaufenden Kleberand 14g auf.

Das Solarpanel 24 besitzt einen umlaufenden Aluminiumrahmen 24b, welcher eine Vertiefung an der Rückseite des Solarpanels bildet, so dass die aufgeklebte Anschlussdose 12 relativ gut mechanisch geschützt ist. Fig. 2 zeigt einen typischen Zustand, in dem Solarpanele ausgeliefert werden.

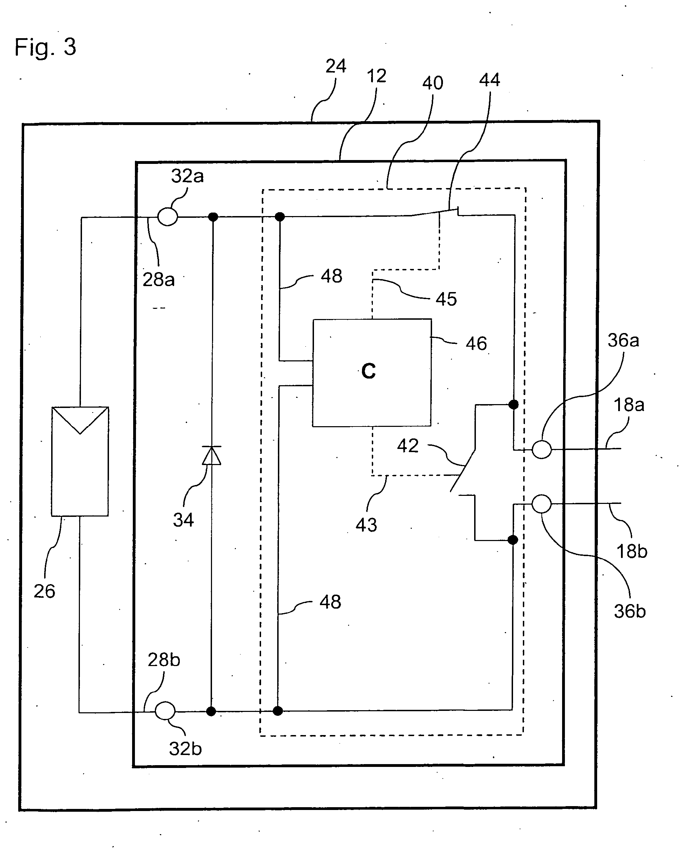

Fig. 3 zeigt in schematischer Darstellung das Solarpanel 24 mit einer Vielzahl von Solarzellen. Die Gesamtheit der photovoltaischen Solarzellen ist mit dem Symbol 26 repräsentiert. Aus dem Solarmodul treten zwei Leiterbändchen 28a, 28b heraus, welche den Pluspol bzw. den Minuspol des Solarmoduls bilden. Die Leiterbändchen 28a und 28b ragen von unten in die Anschlussdose 12 hinein und sind in der Anschlussdose 12 mit eingangsseitigen Anschlusselementen 32a bzw. 32b angeschlossen und kontaktiert. Beispiele für entsprechende Anschlusselemente in Form von Kontaktklemmen finden sich in der DE 10 2007 037 130 und der DE 10 2007 042 547. In der Anschlussdose 12 ist ferner eine Bypassdiode 34 parallel zu den Solarzellen 26 geschaltet.

Die Anschlussdose 12 beherbergt eine Schutzschaltung 40 mit einem Kurzschlussschalter 42, der parallel zu den Solarzellen 26 und der Bypassdiode 34 geschaltet ist. Der Kurzschlussschalter 42 ist unmittelbar an den ausgangsseitigen Anschlusselementen 36a und 36b angeordnet und kann diese kurzschließen. An den ausgangsseitigen Anschlusselementen 36a, 36b sind die Strangkabel 18a bzw. 18b angeschlossen. Dies kann z.B. mittels Kontaktklemmen erfolgen, allerdings ist auch möglich, die Anschlussdose 12 bzw. das Anschlussdosengehäuse 14 unmittelbar mit Steckverbindern auszurüsten.

Die Schutzschaltung 40 umfasst ferner einen Freischalter 44, der seriell zwischen den Kurzschlussschalter 42 und eines der beiden eingangsseitigen Anschlusselemente geschaltet ist, in diesem Beispiel das eingangsseitige Anschlusselement 32a des Pluspols der Solarzellen 26. Der Kurzschlussschalter 42 und der Freischalter 44 werden von einem Controller bzw. einer Steuereinrichtung 46 gesteuert. Die jeweilige Steuerung ist mit den gestrichelten Linien 43, 45, welche z.B. Steuerleitungen repräsentieren, symbolisiert. Die Steuereinrichtung 46 wird über Versorgungsleitungen 48 von den Solarzellen 26 des zugehörigen Solarpanels mit elektrischer Leistung versorgt. Die Versorgungsleitungen 48 sind vom Solarpanel aus gesehen vor dem Freischalter 44 angeschlossen. Fig. 3 zeigt die Schutzschaltung 40 in dem Betriebszustand, d.h. der Kurzschlussschalter 42 ist geöffnet und der Freischalter 44 ist geschlossen, so dass die Solarzellen 26 dieses Solarpanels 24 mit den Strangleitungen 18a, 18b verbunden sind und über die Strangleitungen 18a, 18b die elektrische Leistung dieses Solarpanels eingespeist werden kann.

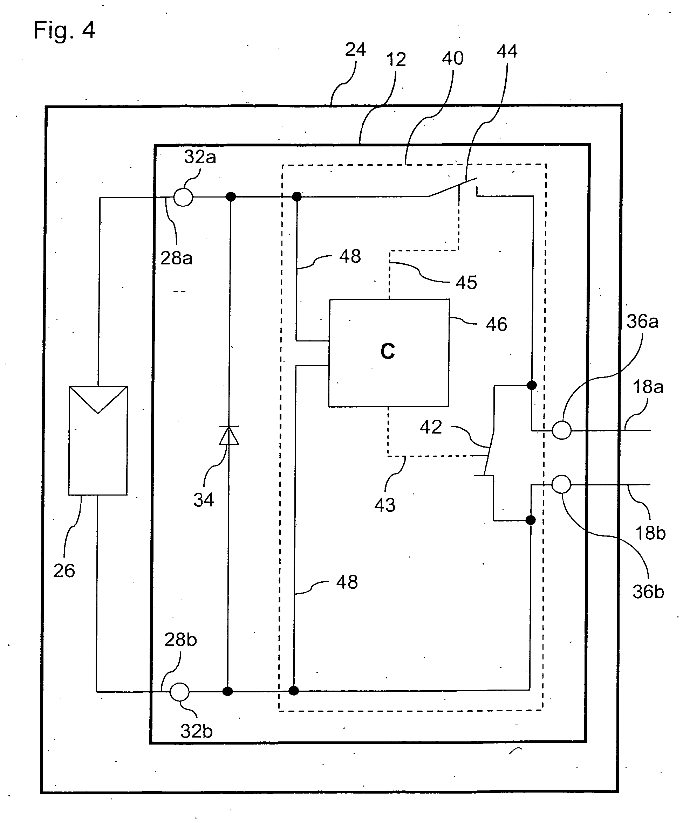

Fig. 4 zeigt das Solarpanel 24 aus Fig. 3, wobei die Schutzschaltung 40 in den Schutzzustand geschaltet ist. In dem Schutzzustand ist der Kurzschlussschalter 42 geschlossen und schließt somit die ausgangsseitigen Anschlusselemente 36a und 36b miteinander kurz, so dass bezogen auf die Strangleitungen 18a und 18b dieses Solarpanel 24 niederohmig gebypasst ist. Die übrigen Solarpanele können weiter elektrische Leistung erzeugen und ins Netz einspeisen, da der Stromkreis der Strangleitungen 18a, 18b über den geschlossenen Kurzschlussschalter 42 geschlossen ist. Es ist lediglich die Strangspannung aufgrund des Fehlens dieses Solarpanels 24 reduziert.

Der serielle Freischalter 44 ist in dem dargestellten Schutzzustand geöffnet, so dass der Kurzschlussschalter 42, obwohl er geschlossen ist, nicht die Solarzellen 26 dieses Solarpanels 24 kurzschließt. Somit erzeugen die Solarzellen 26 dieses Solarpanels 24 keine Verlustleistung in dem geschlossenen Kurzschlussschalter 42. Ferner bleibt die Bypassdiode 34 mit den Solarzellen 26 verbunden. Darüber hinaus wird die Steuereinrichtung 46 auch in dem dargestellten Schutzzustand von den Solarzellen 26 weiter mit elektrischer Leistung versorgt.

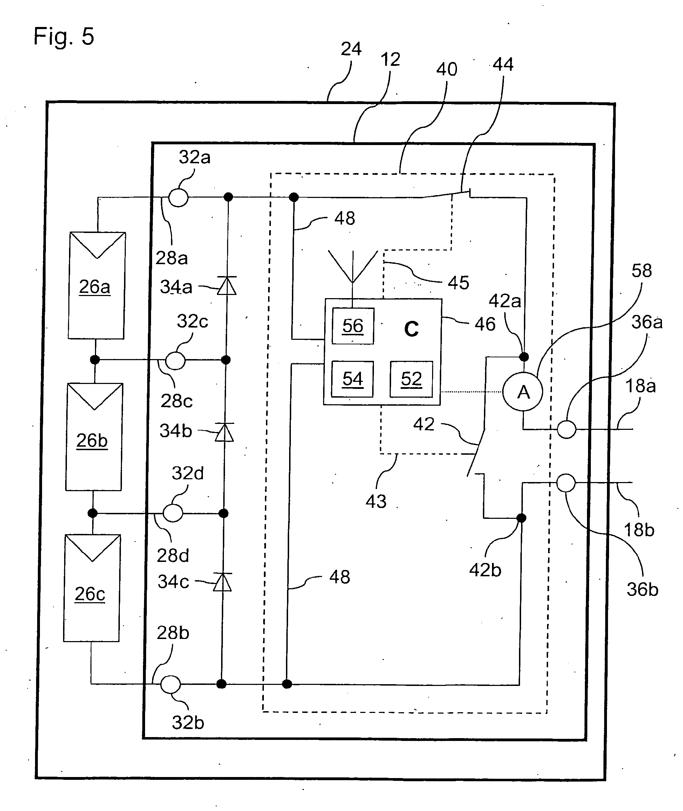

Die in Fig. 5 dargestellte Ausführungsform des Solarpanels 24 weist ein in drei Gruppen von Solarzellen 26a, 26b, 26c aufgeteiltes Solarmodul auf. Die Gruppen von Solarzellen 26a, 26b, 26c bestehen typischerweise wiederum aus einer Vielzahl von einzelnen Solarzellen, die innerhalb der Gruppen seriell und/oder parallel modulintern geschaltet sein können. Wichtig ist lediglich, dass zwischen den Gruppen 26a, 26b, 26c Zwischenabgriffe in Form von weiteren Leiterbändchen 28c und 28d vorgesehen sind. Diese sind mit weiteren eingangsseitigen Anschlusselementen 32c, 32d innerhalb des Anschlussdosengehäuses angeschlossen und kontaktiert. Mit den Zwischenabgriffen können so den Teilgruppen der Solarzellen 26a, 26b, 26c in einem Solarmodul 24 eigene Bypassdioden 34a, 34b, 34c zugeordnet werden, dahingehend dass zu jeder der separat herausgeführten und angeschlossenen Gruppen von Solarzellen 26a, 26b, 26c jeweils eine Bypassdiode 34a, 34b, 34c parallel geschaltet ist.

Ferner umfasst die Steuereinrichtung 46 eine elektronische Funktionselementbaugruppe 52, z.B. eine Strom-, Spannungs- und/oder Temperaturüberwachungseinrichtung oder eine Diebstahlschutzeinrichtung ein MPPT-Steuerungseinrichtung oder ähnliches. Da die Steuereinrichtung 46 vor dem Kurzschlussschalter 42 und dem Freischalter 44 an die beiden Pole des Solarpanels angeschlossen ist, wird auch die Funktionselementbaugruppe 52 sowohl in dem Betriebszustand als auch in dem Schutzzustand von den Solarzellen 26a, 26b, 26c dieses Solarpanels 24 mit elektrischer Leistung versorgt.

Ferner weist die Steuereinrichtung 46 eine Sicherheitseinrichtung 54 auf, welche eine Code-Eingabe erfordert, um den Kurzschlussschalter 42 zu öffnen und den Freischalter 44 zu schließen, das heißt, die Schutzschaltung 40 vom Schutzzustand in den Betriebszustand umzuschalten. Die Steuereinrichtung 46 weist ferner eine Funkeinrichtung 56 auf, die entsprechende Funksignale von einer nicht dargestellten zentralen Steuereinrichtung empfängt, so dass jedes Solarpanel 24 von autorisiertem Personal zentral gesteuert, insbesondere in den Betriebszustand geschaltet werden kann.

In diesem Ausführungsbeispiel wird der Strangstrom mit einem Stromsensor 58 in der Anschlussdose überwacht. Der Stromsensor 58 ist zwischen eines der beiden ausgangsseitigen Anschlusselemente 36a, 36b und den zugehörigen Anschluss 42a bzw. 42b des Kurzschlussschalters 42 geschaltet, um in der Anschlussdose 12 sowohl in dem Betriebszustand als auch in dem Schutzzustand den Strangstrom messen zu können. In dem Betriebszustand fließt der Strom über die Solarzellen 26a, 26b, 26c des zugehörigen Solarpanels 24 und in dem Schutzzustand über den geschlossenen Kurzschlussschalter 42. Mit anderen Worten ist der Stromsensor 58 bezogen auf die an die externen Anschlusselemente 36a, 36b angeschlossenen externen Anschlussleitungen 18a, 18b (Strangleitung) seriell zu dem Kurzschlussschalter 42 geschaltet. Durch diese (Strang-)Stromüberwachung in der Anschlussdose 12 besteht die Möglichkeit, die Schutzschaltung 40 in Ansprechen auf die gemessene Stromhöhe zu aktivieren bzw. zu deaktivieren. Wenn z.B. die Strangleitung 18a, 18b stromlos ist, z.B. weil der DC-Trennschalter vor dem Wechselrichter abgeschaltet wird, schaltet die Schutzschaltung 40 in Ansprechen auf die in der Anschlussdose gemessene Stromunterbrechung selbsttätig in den Schutzzustand. Die Schutzschaltung kann später durch einen Initialstrom durch den Strang, z.B. aus dem Generatoranschlusskasten, vom Schutzzustand wieder in den Betriebszustand geschaltet werden, da die Strangleitung unterbrechungsfrei ist, obwohl sich einige oder sogar alle Schutzschaltungen in dem Schutzzustand befinden.

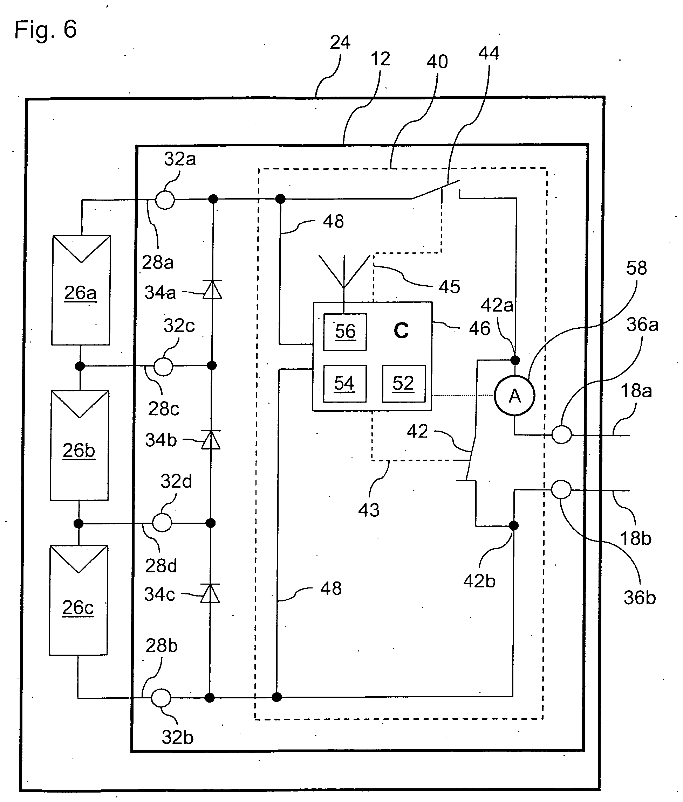

Fig. 6 zeigt die Ausführungsform aus Fig. 5, in dem Schutzzustand. Gemäß dem bevorzugten Ausführungsbeispiel ist der Kurzschlussschalter 42 als Öffner bzw. Ruhekontakt und der Freischalter 44 als Schließer bzw. Arbeitskontakt ausgebildet. Wird die Stromversorgung der Steuereinrichtung 46 von dem zugehörigen Solarpanel 24 unterbrochen, z.B. durch ein Kontaktproblem an einem der eingangsseitigen Anschlusselemente 32a, 32b oder wenn die Steuereinrichtung 46 defekt ist, fällt die Schutzschaltung 40 automatisch in den Schutzzustand, d.h. der Kurzschlussschalter fällt in die geschlossene Position und der Freischalter in die geöffnete Position. Die Schutzschaltung verharrt dann in dem Schutzzustand solange bis ein aktiver Steuereingriff durch die Steuereinrichtung 46 erfolgt, welcher die Schutzschaltung 40 wieder in den Betriebszustand aktiviert, d.h. den Kurzschlussschalter 42 öffnet und den Freischalter 44 schließt. Dies kann z.B. mit entsprechenden Relais oder selbstsperrenden bzw. selbstleitenden MOS-FETs realisiert werden.

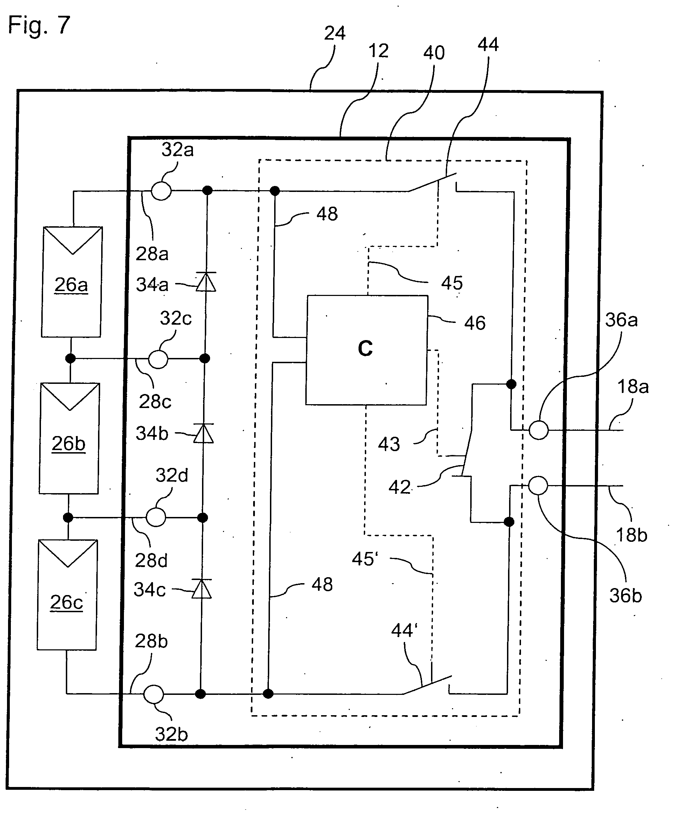

Bezugnehmend auf Fig. 7 ist eine weitere Modifikation der Erfindung dargestellt, bei welcher die Schutzschaltung noch einen zweiten Freischalter 44' aufweist, welcher seriell zwischen den Minuspol der Solarzellen 26 und den Kurzschlussschalter 42 geschaltet ist. Hiermit können beide Anschlüsse 42a und 42b des Kurzschlussschalters ggf. galvanisch von den Solarzellen 26 getrennt werden. Im Gegensatz dazu besteht die Schutzschaltung gemäß Fig. 3 bis Fig. 6 lediglich aus dem Kurzschlussschalter 42, Freischalter 44 und der Steuereinrichtung 46 zum Steuern der beiden Schalter 42, 44.

Für Wartungsarbeiten kann jedes Solarpanel 24 mit der erfindungsgemäßen Schutzschaltung 40 einzeln vom Strang 18a, 18b abgeschaltet werden, ohne die Funktionsweise der jeweils anderen Solarpanele in dem Strang 18a, 18b zu beeinflussen (außer dass die Strangspannung sinkt) und trotzdem kann die in der Anschlussdose 12 des abgeschalteten Solarpanels 24 vorhandene Elektronik 46, 52, 54, 56 von den Solarzellen 26a, 26b, 26c dieses Solarpanels 24 weiter mit elektrischer Leistung versorgt werden. Insbesondere die Steuereinrichtung 46 wird auch in dem Schutzzustand von den Solarzellen 26a, 26b, 26c noch mit elektrischer Leistung versorgt und wird somit in die Lage versetzt, die Schaltvorgänge der Schalter 42 und 44 vom Schutzzustand in den Betriebszustand zu aktivieren.

Es ist dem Fachmann ersichtlich, dass die vorstehend beschriebenen Ausführungsformen beispielhaft zu verstehen sind, und die Erfindung nicht auf diese beschränkt ist, sondern in vielfältiger Weise variiert werden kann, ohne den Schutzbereich der Ansprüche zu verlassen. Ferner definieren die Merkmale unabhängig davon, ob sie in der Beschreibung, den Ansprüchen, den Figuren oder anderweitig offenbart sind auch einzeln wesentliche Bestandteile der Erfindung, selbst wenn sie z.B. in den Ausführungsbeispielen zusammen mit anderen Merkmalen gemeinsam beschrieben sind.

## Patentansprüche

1. Anschlussdose (12) für ein Solarpanel (24) zum elektrischen Anschließen von externen Anschlussleitungen (18a, 18b) an ein Solarpanel, wobei die Anschlussdose (12) umfasst:
ein auf dem Solarpanel (24) montierbares Anschlussdosengehäuse (14),
eingangsseitige Anschlusselemente (32a, 32b) zum Anschließen der spannungsführenden Leiter (28a, 28b) des Pluspols und des Minuspols des Solarpanels (12),
ausgangsseitige Anschlusselemente (36a, 36b) zum Anschließen einer ersten und zweiten externen Anschlussleitung (18a, 18b) an die Anschlussdose (12),
eine Schutzschaltung (40), die einen Betriebszustand und einen Schutzzustand definiert,
wobei in dem Betriebszustand die erste externe Anschlussleitung (18a) mit dem spannungsführenden Leiter (28a) des Pluspols des Solarpanels und die zweite externe Anschlussleitung (18b) mit dem spannungsführenden Leiter (28b) des Minuspols des Solarpanels elektrisch verbunden sind, so dass die von dem Solarpanel erzeugte elektrische Leistung über die erste und zweite externe Anschlussleitung (18a, 18b) abgeführt wird,
wobei die Schutzschaltung (40) einen Kurzschlussschalter (42) zwischen den ausgangsseitigen Anschlusselementen (36a, 36b) der ersten und zweiten externen Anschlussleitung (18a, 18b) und einen Freischalter (44) umfasst,
wobei in dem Schutzzustand der Kurzschlussschalter (42) die ausgangsseitigen Anschlusselemente (36a, 36b) der ersten und zweiten externen Anschlussleitung (18a, 18b) miteinander kurzschließt und der Freischalter (44) den Kurzschlussschalter (42) zumindest einseitig von dem Solarpanel trennt,
ferner umfassend einen Stromsensor (58), zwischen einer der externen Anschlussleitungen (18a, 18b) und dem Kurzschlussschalter (42), so dass in dem Schutzzustand der durch die externen Anschlussleitungen (18a, 18b) fließende Strom gemessen werden kann,
**dadurch gekennzeichnet, dass**
die Schutzschaltung ausgebildet ist, in dem Schutzzustand durch einen Initialstrom durch den Strang vom Schutzzustand wieder in den Betriebszustand zu schalten.

2. Anschlussdose (12) für ein Solarpanel (24) nach Anspruch 1,
wobei der Kurzschlussschalter (42) in der Anschlussdose von den Polen (28a, 28b) des Solarpanels aus gesehen direkt vor den ausgangsseitigen Anschlusselementen (36a, 36b) der ersten und zweiten externen Anschlussleitung (18a, 18b) installiert ist und der Freischalter (44) in der Anschlussdose (12) seriell zwischen das eingangsseitige Anschlusselement (32a) des spannungsführenden Leiters (28a) des Pluspols des Solarpanels oder das eingangsseitige Anschlusselement (32b) des spannungsführenden Leiters (28b) des Minuspols des Solarpanels und den zugehörigen Anschluss des Kurzschlussschalters (42) geschaltet ist.

3. Anschlussdose (12) für ein Solarpanel nach Anspruch 1 oder 2, wobei die Anschlussdose zumindest eine Bypassschaltung (34) zur Kompensation von Abschattungen enthält und der Freischalter (44) seriell zu der zumindest einen Bypassschaltung (34) zur Kompensation von Abschattungen und/oder der Kurzschlussschalter (42) parallel zu der zumindest einen Bypassschaltung (34) zur Kompensation von Abschattungen geschaltet ist.

4. Anschlussdose (12) für ein Solarpanel nach Anspruch 3, wobei die zumindest eine Bypassschaltung (34) zur Kompensation von Abschattungen von den Polen (28a, 28b) des Solarpanels aus gesehen vor den Freischalter (44) und den Kurzschlussschalter (42) geschaltet ist, so dass die zumindest eine Bypassschaltung (34) zur Kompensation von Abschattungen auch in dem Schutzzustand mit dem Solarpanel verbunden bleibt.

5. Anschlussdose (12) für ein Solarpanel (24) nach einem der vorstehenden Ansprüche, für ein in mehrere separat kontaktierbare Gruppen von Solarzellen (26a, 26b, 26c) unterteiltes Solarpanel (24) mit elektrischen Zwischenabgriffen zwischen den Gruppen, umfassend weitere eingangsseitige Anschlusselemente (32c, 32d) zum Anschließen der spannungsführenden Leiter (28c, 28d) der Zwischenabgriffe, und mehrere Bypassschaltungen (34a, 34b, 34c) zur Kompensation von Abschattungen, welche jeweils parallel zu den zugehörigen Gruppen von Solarzellen (26a, 26b, 26c) geschaltet sind, wenn die Anschlussdose (12) auf dem Solarpanel (24) montiert ist,
wobei der Kurzschlussschalter (42) parallel zu den Bypassschaltungen (34a, 34b, 34c) zur Kompensation von Abschattungen und den Gruppen von Solarzellen (26a, 26b, 26c) geschaltet ist, wenn die Anschlussdose (12) auf dem Solarpanel (24) montiert ist und
wobei der Freischalter (44) in Serie zwischen den Kurzschlussschalter (42) und die Bypassschaltungen (26a, 26b, 26c) zur Kompensation von Abschattungen und die Gruppen von Solarzellen (26a, 26b, 26c) geschaltet ist, wenn die Anschlussdose (12) auf dem Solarpanel (24) montiert ist, um in dem Schutzzustand den Kurzschlussschalter (42) mittels des Freischalters (44) von allen Gruppen von Solarzellen und Bypassschaltungen zur Kompensation von Abschattungen zu trennen.

6. Anschlussdose (12) für ein Solarpanel (24) nach einem der vorstehenden Ansprüche, wobei der Kurzschlussschalter (42) und der Freischalter (44) in dem Anschlussdosengehäuse (14) von den Polen (28a, 28b) des Solarpanels aus gesehen vor jeglichen außerhalb der Anschlussdose liegenden lösbaren Verbindern eingebaut sind.

7. Anschlussdose (12) für ein Solarpanel (24) nach einem der vorstehenden Ansprüche, umfassend eine Steuereinrichtung (46), welche das Umschalten der Schutzschaltung (40) vom Schutzzustand in den Betriebszustand steuert, wobei die Steuereinrichtung (46) in dem Schutzzustand von dem zugehörigen Solarpanel mit elektrischer Energie versorgt wird.

8. Anschlussdose (12) für ein Solarpanel (24) nach einem der vorstehenden Ansprüche, wobei der Kurzschlussschalter (42) als Öffner ausgebildet ist und im Ruhezustand geschlossen ist und/oder wobei der Freischalter (44) als Schließer ausgebildet ist und im Ruhezustand geöffnet ist.

9. Anschlussdose (12) für ein Solarpanel (24) nach Anspruch 8, wobei sich in dem Schutzzustand der Kurzschlussschalter (42) und der Freischalter (44) im Ruhezustand befinden und aus dem jeweiligen Ruhezustand mittels der Steuereinrichtung (46) aktiviert werden, um in Ansprechen auf die Aktivierung die Schutzschaltung (40) vom Ruhe-Schutzzustand in den Betriebszustand umzuschalten.

10. Anschlussdose (12) für ein Solarpanel (24) nach Anspruch 9, wobei die Steuereinrichtung (46) eine Sicherheitseinrichtung (54) umfasst, welche für die Aktivierung der Schutzschaltung (40) vom Schutzzustand in den Betriebszustand eine Autorisierung erfordert.

11. Anschlussdose (12) für ein Solarpanel (24) nach einem der vorstehenden Ansprüche,
wobei in der Anschlussdose (12) zumindest eine Diebstahlschutzeinrichtung, eine Maximum-Powerpoint-Tracking-Steuerungseinrichtung, eine Spannungsüberwachungseinrichtung, eine Stromüberwachungseinrichtung und/oder eine Temperaturüberwachungseinrichtung eingebaut sind, welche von den Polen (28a, 28b) des Solarpanels aus gesehen vor den Freischalter (44) und den Kurzschlussschalter (42) geschaltet sind und die Diebstahlschutzeinrichtung, die Maximum-Powerpoint-Tracking-Steuerungseinrichtung, die Spannungsüberwachungseinrichtung, die Stromüberwachungseinrichtung bzw. die Temperaturüberwachungseinrichtung auch in dem Schutzzustand von dem Solarpanel mit elektrischer Leistung versorgt werden.

12. Schutzschaltung (40) zum Einbau in eine Anschlussdose (12) für ein Solarpanel (24), mittels welcher die spannungsführenden Leiter (28a, 28b) des Pluspols und des Minuspols des Solarpanels angeschlossen und die erste und zweite externe Anschlussleitung (18a, 18b) in einem Solargenerator mit dem Solarpanel elektrisch verbunden werden,
wobei die Schutzschaltung (40) einen Kurzschlussschalter (42) zwischen ausgangsseitigen Anschlusselementen (36a, 36b) der ersten und zweiten externen Anschlussleitung (18a, 18b) und einen Freischalter (44) umfasst und einen Betriebszustand definiert, in welchem die elektrische Leistung des Solarpanels über die erste und zweite externe Anschlussleitung (18a, 18b) abgeführt wird und einen Schutzzustand definiert, in welchem der Kurzschlussschalter (42) die ausgangsseitigen Anschlusselemente (36a, 36b) der ersten und zweiten externen Anschlussleitung (18a, 18b) miteinander kurzschließt und der Freischalter (44) den Kurzschlussschalter (42) zumindest einseitig von dem Solarpanel trennt und die externen Anschlussleitungen in Bezug auf das zugehörige Solarpanel leistungsfrei geschaltet sind,
wobei eine Steuereinrichtung (46) zum Steuern der Schutzschaltung (40) umfasst ist und die Steuereinrichtung (46) in der Anschlussdose (12) von den Polen des Solarpanels gesehen vor dem Freischalter (44) angeordnet ist, um in dem Schutzzustand von dem zugehörigen Solarpanel mit elektrischer Leistung versorgt zu werden und die Schutzschaltung (40) aus dem Schutzzustand in den Betriebszustand aktivieren zu können,
ferner umfassend einen Stromsensor (58), zwischen einer der externen Anschlussleitungen (18a, 18b) und dem Kurzschlussschalter (42), so dass in dem Schutzzustand der durch die externen Anschlussleitungen (18a, 18b) fließende Strom gemessen werden kann,
**dadurch gekennzeichnet, dass**
der Schutzzustand ein Ruhezustand ist, in welchen die Schutzschaltung (40) automatisch bei Stromlosigkeit fällt und dort verbleibt, solange bis die Schutzschaltung (40) von der Steuereinrichtung (46) wieder aktiviert wird und
die Schutzschaltung ausgebildet ist, in dem Schutzzustand durch einen Initialstrom durch den Strang vom Schutzzustand wieder in den Betriebszustand zu schalten.

13. Verfahren zum Liefern und Aufbauen eines Solargenerators, wobei
eine Mehrzahl von Solarpanelen (24) jeweils mit einer Anschlussdose (12) mit integrierter Schutzschaltung (40) gemäß einem der vorstehenden Ansprüche herstellerseitig in dem Schutzzustand an den Aufbauort geliefert werden,
die Solarpanele (24) am Aufbauort installiert und mit den externen Anschlussleitungen (18a, 18b) verkabelt werden und der Solargenerator den Norm-gerechten Inbetriebnahmeprüfungen unterzogen wird und
die Schutzschaltungen (40) der Solarpanele (24) erst nach der Installation und nach den Inbetriebnahmeprüfungen des Solargenerators vom Schutzzustand in den Betriebszustand überführt werden, wobei jeweils an den Solarpanelen mit dem zu der Anschlussdose (12) gehörigen Stromsensor (58) der durch die externen Anschlussleitungen (18a, 18b) fließende Strom gemessen wird
**dadurch gekennzeichnet, dass**
die Schutzschaltungen (40) durch einen Initialstrom durch den Strang vom Schutzzustand in den Betriebszustand geschaltet werden.

14. Verfahren nach Anspruch 13,
wobei das Aktivieren der Schutzschaltung (40) vom Schutzzustand in den Betriebszustand durch die Steuereinrichtung (46) eine Autorisierung erfordert.

15. Verfahren zum Freischalten und wieder in den Betriebszustand schalten eines oder mehrerer Solarpanele (24) jeweils mit einer Anschlussdose (12) gemäß einem der Patentansprüche 1 bis 11 oder der Schutzschaltung gemäß Patentanspruch 12, in einem installierten und unter Belichtung stehenden und Spannung erzeugenden Solargenerator zur Wartung oder bei einem Störfall,
**dadurch gekennzeichnet, dass**
das oder die Solarpanele (24) einzeln von den übrigen Solarpanelen (24) des Solargenerators freigeschaltet werden, in dem in der zugehörigen Schutzschaltung (40) jeweils in einem ersten Schritt zunächst der Kurzschlussschalter (42) geschlossen wird, um die ausgangsseitigen Anschlusselemente (38a, 38b) der ersten und zweiten externen Anschlussleitung (18a, 18b) miteinander kurzzuschließen und in einem nachfolgenden zweiten Schritt der Freischalter (44) geöffnet wird und den bereits geschlossenen Kurzschlussschalter (42) zumindest von einem Pol (28a, 28b) des Solarpanels trennt, um die Schutzschaltung vom Betriebszustand in den Schutzzustand zu überführen und
wobei jeweils an den Solarpanelen mit dem zu der Anschlussdose (12) gehörigen Stromsensor (58) der durch die externen Anschlussleitungen (18a, 18b) fließende Strom gemessen wird und die Schutzschaltungen (40) durch einen Initialstrom durch den Strang vom Schutzzustand wieder in den Betriebszustand geschaltet werden.

## Claims

1. A junction box (12) for a solar panel (24) for electrically connecting external connection lines (18a, 18b) to a solar panel, the junction box (12) comprising:
a junction box housing (14) mountable to the solar panel (24);
input-side connection elements (32a, 32b) for connecting the voltage-carrying conductors (28a, 28b) of the positive pole and negative pole of the solar panel (12);
output-side connection elements (36a, 36b) for connecting first and second external connection lines (18a, 18b) to the junction box (12); and
a protective circuit (40) that defines an operating state and a protected state,
wherein in the operating state, the first external connection line (18a) is electrically connected to the voltage-carrying conductor (28a) of the positive pole of the solar panel and the second external connection line (18b) is electrically connected to the voltage-carrying conductor (28b) of the negative pole of the solar panel so that the electrical power produced by the solar panel is delivered via the first and second external connection lines (18a, 18b);
wherein the protective circuit (40) comprises a short-circuiting switch (42) between the output-side connection elements (36a, 36b) of the first and second external connection lines (18a, 18b), and an isolating switch (44); and
wherein in the protected state, the short-circuiting switch (42) short-circuits the output-side connection elements (36a, 36b) of the first and second external connection lines (18a, 18b) to each other, and the isolating switch (44) disconnects the short-circuiting switch (42) from the solar panel on at least one side;
furthermore comprising a current sensor (58) between one of the external connection lines (18a, 18b) and the short-circuiting switch (42) so that in the protected state it is possible to measure the current flowing in the external connection lines (18a, 18b);
**characterised in that**
the protective circuit is configured, when in the protected state, to be responsive to an initial current through the string to switch back from the protected state into the operating state.

2. The junction box (12) for a solar panel (24) according to claim 1,
wherein the short-circuiting switch (42) is installed in the junction box directly upstream of the output-side connection elements (36a, 36b) of the first and second external connection lines (18a, 18b) as seen from the poles (28a, 28b) of the solar panel, and the isolating switch (44) is connected in series, in the junction box (12), between the input-side connection element (32a) of the voltage-carrying conductor (28a) of the positive pole of the solar panel or the input-side connection element (32b) of the voltage-carrying conductor (28b) of the negative pole of the solar panel and the associated connection of the short-circuiting switch (42).

3. The junction box (12) for a solar panel according to claim 1 or 2, wherein the junction box includes at least one bypass circuit (34) for compensating shadowing effects, and wherein the isolating switch (44) is connected in series with the at least one bypass circuit (34) for compensating shadowing effects and/or the short-circuiting switch (42) is connected in parallel to the at least one bypass circuit (34) for compensating shadowing effects.

4. The junction box (12) for a solar panel according to claim 3, wherein the at least one bypass circuit (34) for compensating shadowing effects is connected upstream of the isolating switch (44) and the short-circuiting switch (42) as seen from the poles (28a, 28b) of the solar panel, so that the at least one bypass circuit (34) for compensating shadowing effects remains connected to the solar panel even in the protected state.

5. The junction box (12) for a solar panel (24) according to any one of the preceding claims, for a solar panel (24) that is divided into a plurality of separately contactable groups of solar cells (26a, 26b, 26c), with intermediate electrical taps between the groups, comprising further input-side connection elements (32c, 32d) for connecting the voltage-carrying conductors (28c, 28d) of the intermediate taps, and a plurality of bypass circuits (34a, 34b, 34c) for compensating shadowing effects, which are respectively connected in parallel to the associated groups of solar cells (26a, 26b, 26c) when the junction box (12) is mounted on the solar panel (24);
wherein the short-circuiting switch (42) is connected in parallel to the bypass circuits (34a, 34b, 34c) for compensating shadowing effects and to the groups of solar cells (26a, 26b, 26c) when the junction box (12) is mounted on the solar panel (24); and
wherein the isolating switch (44) is connected in series between the short-circuiting switch (42) and the bypass circuits (26a, 26b, 26c) for compensating shadowing effects and the groups of solar cells (26a, 26b, 26c) when the junction box (12) is mounted on the solar panel (24), in order to disconnect, in the protected state, the short-circuiting switch (42) from all of the groups of solar cells and bypass circuits for compensating shadowing effects by means of the isolating switch (44).

6. The junction box (12) for a solar panel (24) according to any one of the preceding claims, wherein the short-circuiting switch (42) and the isolating switch (44) are installed in the junction box housing (14) upstream of any detachable connectors situated outside the junction box as seen from the poles (28a, 28b) of the solar panel.

7. The junction box (12) for a solar panel (24) according to any one of the preceding claims, comprising a control device (46) that controls the switching of the protective circuit (40) from the protected state into the operating state, wherein in the protected state the control device (46) is supplied with electrical power by the associated solar panel.

8. The junction box (12) for a solar panel (24) according to any one of the preceding claims, wherein the short-circuiting switch (42) is implemented as a break contact switch which is closed in the inactive state, and/or wherein the isolating switch (44) is implemented as a make contact switch and is open in the inactive state.

9. The junction box (12) for a solar panel (24) according to claim 8, wherein in the protected state, the short-circuiting switch (42) and the isolating switch (44) are in their inactive states and are activated from the respective inactive state by the control device (46) in order to switch the protective circuit (40) from the inactive protected state into the operating state in response to the activation.

10. The junction box (12) for a solar panel (24) according to claim 9, wherein the control device (46) comprises a safety device (54) that requires an authorization for the activation of the protective circuit (40) from the protected state into the operating state.

11. The junction box (12) for a solar panel (24) according to any one of the preceding claims, wherein the junction box (12) includes installed therein at least an anti-theft device, a maximum power point tracking control device, a voltage monitoring device, a current monitoring device, and/or a temperature monitoring device, which are connected upstream of the isolating switch (44) and the short-circuiting switch (42) as seen from the poles (28a, 28b) of the solar panel, and wherein the anti-theft device, the maximum power point tracking control device, the voltage monitoring device, the current monitoring device and the temperature monitoring device are supplied with electrical power by the solar panel even in the protected state.

12. A protective circuit (40) for being installed in a junction box (12) for a solar panel (24), which is used to connect the voltage-carrying conductors (28a, 28b) of the positive pole and the negative pole of the solar panel and to electrically connect the first and second external connection lines (18a, 18b) in a solar generator to the solar panel;
wherein the protective circuit (40) comprises a short-circuiting switch (42) between output-side connection elements (36a, 36b) of the first and second external connection lines (18a, 18b) and an isolating switch (44) and defines an operating state in which the electrical power of the solar panel is delivered via the first and second external connection lines (18a, 18b), and a protected state in which the short-circuiting switch (42) short-circuits the output-side connection elements (36a, 36b) of the first and second external connection lines (18a, 18b) to each other and the isolating switch (44) disconnects the short-circuiting switch (42) from the solar panel on at least one side and the external connection lines are switched to a powerless state with regard to the associated solar panel;
wherein a control device (46) is included for controlling the protective circuit (40), and wherein the control device (46) is arranged within the junction box (12) upstream of the isolating switch (44) as seen from the poles of the solar panel, in order to be supplied with electrical power by the associated solar panel in the protected state and to be able to activate the protective circuit (40) from the protected state into the operating state;
furthermore comprising a current sensor (58) between one of the external connection lines (18a, 18b) and the short-circuiting switch (42) so that in the protected state it is possible to measure the current flowing in the external connection lines (18a, 18b);
**characterised in that**
the protected state is an inactive state automatically adopted by the protective circuit (40) when not being powered to remain there until the protective circuit (40) is reactivated by the control device (46); and
wherein the protective circuit is configured, when in the protected state, to be responsive to an initial current through the string to switch back from the protected state into the operating state.

13. A method for delivering and installing a solar generator, wherein
a plurality of solar panels (24), each one with a respective junction box (12) with integrated protective circuit (40) according to any one of the preceding claims, is delivered to the installation site in the protected state, by the manufacturer;
the solar panels (24) are installed at the installation site and are wired to the external connection lines (18a, 18b), and the solar generator is subjected to the standardized commissioning tests; and
the protective circuits (40) of the solar panels (24) are switched from the protected state into the operating state only after the installation and the commissioning tests of the solar generator have been completed, wherein the current flowing through the external connection lines (18a, 18b) is measured at the respective solar panels using the current sensor (58) associated with the junction box (12);
**characterised in that**
protective circuits (40) are switched from the protected state into the operating state by an initial current through the string.

14. The method according to claim 13,
wherein the activation of the protective circuit (40) from the protected state into the operating state by the control device (46) requires an authorization.

15. A method for disconnecting and switching back into the operating state one or more solar panels (24) each of which comprises a junction box (12) according to any one of claims 1 to 11 or the protective circuit according to claim 12, in an installed, light-exposed and voltage-producing solar generator, for maintenance work or in the case of an incident; **characterised in that**
the one or more solar panel(s) (24) is/are individually disconnected from the other solar panels (24) of the solar generator by first closing the short-circuiting switch (42) in the associated protective circuit (40) in a first step, in order to short-circuit the output-side connection elements (38a, 38b) of the first and second external connection lines (18a, 18b) to each other, and then opening the isolating switch (44) in a subsequent second step and disconnecting the already closed short-circuiting switch (42) from at least one pole (28a, 28b) of the solar panel in order to put the protective circuit from the operating state into the protected state;
wherein, in the respective solar panels, the current flowing through the external connection lines (18a, 18b) is measured using the current sensor (58) associated with the junction box (12), and the protective circuits (40) are switched back from the protected state into the operating state by an initial current through the string.

## Revendications

1. Boîte de connexions (12) pour un panneau solaire (24), en vue de la connexion électrique de lignes de raccordement externes (18a, 18b) à un panneau solaire, la boîte de connexions (12) comprenant :
un boîtier de connexions (14) pouvant être monté sur le panneau solaire (24),
des éléments de connexion (32a, 32b) côté entrée, destinés au raccordement des conducteurs sous tension (28a, 28b) du pôle positif et du pôle négatif du panneau solaire (24),
des éléments de connexion (36a, 36b) côté sortie, destinés au raccordement d'une première et d'une deuxième ligne de raccordement (18a, 18b) à la boîte de connexions (12),
un circuit de protection (40) qui définit un état de fonctionnement et un état de protection,
sachant qu'à l'état de fonctionnement, la première ligne de raccordement externe (18a) est reliée électriquement au conducteur sous tension (28a) du pôle positif du panneau solaire, et la deuxième ligne de raccordement externe (18b) est reliée électriquement au conducteur sous tension (28b) du pôle négatif du panneau solaire, de sorte que la puissance électrique produite par le panneau solaire est évacuée par l'intermédiaire des première et deuxième lignes de raccordement externes (18a, 18b),
sachant que le circuit de protection (40) comprend un interrupteur de court-circuit (42), entre les éléments de connexion (36a, 36b) côté sortie des première et deuxième lignes de raccordement externes (18a, 18b), et un sectionneur (44),
sachant qu'à l'état de protection, l'interrupteur de court-circuit (42) met en court-circuit entre eux les éléments de connexion (36a, 36b) côté sortie des première et deuxième lignes de raccordement externes (18a, 18b), et le sectionneur (44) sépare l'interrupteur de court-circuit (42) du panneau solaire, au moins sur un côté,
comprenant en outre un capteur de courant (58) entre l'une des lignes de raccordement externes (18a, 18b) et l'interrupteur de court-circuit (42), de sorte qu'à l'état de protection, il est possible de mesurer le courant circulant dans les lignes de raccordement externes (18a, 18b) **caractérisée en ce que**
le circuit de protection est conçu pour commuter, lorsqu'il est à l'état de protection, de l'état de protection de nouveau à l'état de fonctionnement, du fait d'un courant initial passant dans la chaîne.

2. Boîte de connexions (12) pour un panneau solaire (24) selon la revendication 1,
dans laquelle l'interrupteur de court-circuit (42) est installé dans la boîte de connexions, directement avant les éléments de connexion (36a, 36b) côté sortie des première et deuxième lignes de raccordement externes (18a, 18b), vu depuis les pôles (28a, 28b) du panneau solaire, et le sectionneur (44) est monté, dans la boîte de connexions (12), en série entre l'élément de connexion (32a) côté entrée du conducteur (28a) sous tension du pôle positif du panneau solaire ou l'élément de connexion (32b) côté entrée du conducteur (28b) sous tension du pôle négatif du panneau solaire et la borne associée de l'interrupteur de court-circuit (42).

3. Boîte de connexions (12) pour un panneau solaire selon la revendication 1 ou 2, la boîte de connexions contenant au moins un circuit de dérivation (34) destiné à compenser des obscurcissements, et le sectionneur (44) étant monté en série avec le circuit de dérivation (34), au nombre d'au moins un, aux fins de compensation d'obscurcissements, et/ou l'interrupteur de court-circuit (42) étant monté en parallèle avec le circuit de dérivation (34), au nombre d'au moins un, en vue de la compensation d'obscurcissements.

4. Boîte de connexions (12) pour un panneau solaire selon la revendication 3, le circuit de dérivation (34), au nombre d'au moins un, destiné à compenser des obscurcissements, étant monté avant le sectionneur (44) et l'interrupteur de court-circuit (42), vu depuis les pôles (28a, 28b) du panneau solaire, de sorte que le circuit de dérivation (34), au nombre d'au moins un, destiné à compenser des obscurcissements, reste connecté au panneau solaire, y compris à l'état de protection.

5. Boîte de connexions (12) pour un panneau solaire (24) selon une des revendications précédentes, destinée à un panneau solaire (24) qui est divisé en plusieurs groupes de cellules solaires (26a, 26b, 26c) pouvant être connectés séparément, avec des prises électriques intermédiaires entre les groupes, comprenant d'autres éléments de connexion (32c, 32d) côté entrée destinés au raccordement des conducteurs sous tension (28c, 28d) des prises intermédiaires, et plusieurs circuits de dérivation (34a, 34b, 34c), destinés à compenser des obscurcissements, qui sont montés respectivement en parallèle avec les groupes de cellules solaires (26a, 26b, 26c) associés, lorsque la boîte de connexions (12) est installée sur le panneau solaire (24),
l'interrupteur de court-circuit (42) étant monté en parallèle avec les circuits de dérivation (34a, 34b, 34c), destinés à compenser des obscurcissements, et avec les groupes de cellules solaires (26a, 26b, 26c), lorsque la boîte de connexions (12) est installée sur le panneau solaire (24), et
le sectionneur (44) étant monté en série entre l'interrupteur de court-circuit (42) et les circuits de dérivation (26a, 26b, 26c), destinés à compenser des obscurcissements, et les groupes de cellules solaires (26a, 26b, 26c), lorsque la boîte de connexions (12) est installée sur le panneau solaire (24), afin de séparer, à l'état de protection, l'interrupteur de court-circuit (42) au moyen du sectionneur (44) de tous les groupes de cellules solaires et circuits de dérivation destinés à compenser des obscurcissements.

6. Boîte de connexions (12) pour un panneau solaire (24) selon une des revendications précédentes, l'interrupteur de court-circuit (42) et le sectionneur (44) étant montés dans le boîtier de connexions (14), avant les éventuels connecteurs amovibles situés à l'extérieur de la boîte de connexions, vu depuis les pôles (28a, 28b) du panneau solaire.

7. Boîte de connexions (12) pour un panneau solaire (24) selon une des revendications précédentes, comprenant un dispositif de commande (46) qui commande la commutation du circuit de protection (40) de l'état de protection à l'état de fonctionnement, le dispositif de commande (46), à l'état de protection, étant alimenté en énergie électrique par le panneau solaire associé.

8. Boîte de connexions (12) pour un panneau solaire (24) selon une des revendications précédentes, dans laquelle l'interrupteur de court-circuit (42) est réalisé sous forme de contact à ouverture et est fermé à l'état de repos, et/ou le sectionneur (44) est réalisé comme contact à fermeture et est ouvert à l'état de repos.

9. Boîte de connexions (12) pour un panneau solaire (24) selon la revendication 8, dans laquelle, à l'état de protection, l'interrupteur de court-circuit (42) et le sectionneur (44) sont à l'état de repos et sont activés à partir de l'état de repos respectif, au moyen du dispositif de commande (46), afin de commuter, en réponse à l'activation, le circuit de protection (40) de l'état de protection de repos à l'état de fonctionnement.

10. Boîte de connexions (12) pour un panneau solaire (24) selon la revendication 9, dans laquelle le dispositif de commande (46) comprend un dispositif de sécurité (54) qui requiert une autorisation pour l'activation du circuit de protection (40) de l'état de protection à l'état de fonctionnement.

11. Boîte de connexions (12) pour un panneau solaire (24) selon une des revendications précédentes, sachant que sont montés dans la boîte de connexions (12), au moins un dispositif de protection contre le vol, un dispositif de commande de poursuite de point de puissance maximum, un dispositif de surveillance de tension, un dispositif de surveillance de courant et/ou un dispositif de surveillance de température, qui sont branchés avant le sectionneur (44) et l'interrupteur de court-circuit (42), vu depuis les pôles (28a, 28b) du panneau solaire, et le dispositif de protection contre le vol, le dispositif de commande de poursuite de point de puissance maximum, le dispositif de surveillance de tension, le dispositif de surveillance de courant et/ou le dispositif de surveillance de température sont alimentés avec de la puissance électrique par le panneau solaire, y compris à l'état de protection.

12. Circuit de protection (40), destiné à être monté dans une boîte de connexions (12) pour un panneau solaire (24), au moyen duquel les conducteurs sous tension (28a, 28b) du pôle positif et du pôle négatif du panneau solaire sont raccordés et les première et deuxième lignes de raccordement externes (18a, 18b) sont reliées électriquement au panneau solaire dans une génératrice solaire,
le circuit de protection (40) comprenant un interrupteur de court-circuit (42), entre des éléments de connexion (36a, 36b) côté sortie des première et deuxième lignes de raccordement externes (18a, 18b), et un sectionneur (44) et définit un état de fonctionnement dans lequel la puissance électrique du panneau solaire est évacuée par l'intermédiaire des première et deuxième lignes de raccordement externes (18a, 18b), et définit un état de protection dans lequel l'interrupteur de court-circuit (42) met en court-circuit entre eux les éléments de connexion (36a, 36b) côté sortie des première et deuxième lignes de raccordement externes (18a, 18b), et le sectionneur (44) sépare l'interrupteur de court-circuit (42) du panneau solaire, au moins sur un côté, et les lignes de raccordement externes sont branchées de manière à être sans puissance par rapport au panneau solaire associé,
sachant qu'il est prévu un dispositif de commande (46) destiné à commander le circuit de protection (40), et que le dispositif de commande (46) est prévu dans la boîte de connexions (12) avant le sectionneur (44), vu depuis les pôles du panneau solaire, afin d'être alimenté, à l'état de protection, en puissance électrique par le panneau solaire associé et de pouvoir activer le circuit de protection (40) pour le faire passer de l'état de protection à l'état de fonctionnement,
comprenant en outre un capteur de courant (58), entre l'une des lignes de raccordement externes (18a, 18b) et l'interrupteur de court-circuit (42), de manière à permettre, à l'état de protection, de mesurer le courant circulant dans les lignes de raccordement externes (18a, 18b), **caractérisé en ce que**
l'état de protection est un état de repos auquel le circuit de protection (40) passe automatiquement en l'absence de courant et dans lequel il reste jusqu'à ce que le circuit de protection (40) soit de nouveau activé par le dispositif de commande (46), et
le circuit de protection est conçu pour commuter, lorsqu'il est à l'état de protection, de l'état de protection de nouveau à l'état de fonctionnement, du fait d'un courant initial passant dans la chaîne.

13. Procédé de fourniture et d'installation d'une génératrice solaire, selon lequel
une pluralité de panneaux solaires (24), dotés respectivement d'une boîte de connexions (12) à circuit de protection (40) intégré selon une des revendications précédentes, sont livrés sur le lieu d'installation, en étant mis à l'état de protection par le fabricant,
les panneaux solaires (24) sont mis en place sur le lieu d'installation et reliés aux lignes de raccordement externes (18a, 18b), et la génératrice solaire est soumise aux essais de mise en service, conformément aux normes, et
les circuits de protection (40) des panneaux solaires (24) sont amenés de l'état de protection à l'état de fonctionnement seulement après l'installation et après les essais de mise en service de la génératrice solaire, en mesurant respectivement sur les panneaux solaires le courant circulant dans les lignes de raccordement externes (18a, 18b), à l'aide du capteur de courant (58) associé à la boîte de connexions (12),
**caractérisé en ce que**
les circuits de protection (40) sont commutés de l'état de protection à l'état de fonctionnement par un courant initial passant dans la chaîne.

14. Procédé selon la revendication 13, selon lequel l'activation du circuit de protection (40) par le dispositif de commande (46), pour passer de l'état de protection à l'état de fonctionnement, requiert une autorisation.

15. Procédé de mise hors tension et de remise à l'état de fonctionnement d'un ou plusieurs panneaux solaires (24), dotés chacun d'une boîte de connexions (12) selon une des revendications 1 à 11 ou du circuit de protection selon la revendication 12, dans une génératrice solaire installée et exposée à la lumière et produisant de la tension, à des fins de maintenance ou en cas de dysfonctionnement,
**caractérisé en ce que**
le ou les panneaux solaires (24) sont mis hors tension individuellement par rapport aux autres panneaux solaires (24) de la génératrice solaire, par le fait que dans le circuit de protection (40) associé, lors d'une première étape, l'interrupteur de court-circuit (42) est d'abord fermé pour mettre les éléments de connexion (38a, 38b) côté sortie des première et deuxième lignes de raccordement externes (18a, 18b) en court-circuit entre eux et, lors d'une deuxième étape qui suit, le sectionneur (44) est ouvert et sépare l'interrupteur de court-circuit (42), déjà fermé, d'au moins un pôle (28a, 28b) du panneau solaire pour faire passer le circuit de protection de l'état de fonctionnement à l'état de protection, et
le courant circulant dans les lignes de raccordement externes (18a, 18b) est mesuré respectivement sur les panneaux solaires, avec le capteur de courant (58) associé à la boîte de connexions (12), et les circuits de protection (40) sont commutés de l'état de protection de nouveau à l'état de fonctionnement, du fait d'un courant initial passant dans la chaîne.
